# EUROPEAN PATENT APPLICATION

(11) **EP 2 621 028 A1**
(43) Date of publication of application: **31.07.2013**
(21) Application number: 11826468.8
(22) Date of filing: 20.09.2011
(51) Int. Cl.: H01R 13/64, H01R 13/639, H01R 13/703

(54) **RECEPTACLE AND PLUG**

(30) Priority: 22.09.2010 JP 2010212740
(71) Applicant: Panasonic Corporation, Osaka 571-8501 (JP)
(72) Inventor: YOSHIKAWA, Keisuke, Osaka 540-6207 (JP)
(74) Representative: Appelt, Christian W.
(86) International application number: PCT/IB2011/002168
(87) International publication number: WO 2012/038797

(57) **Abstract**

A DC receptacle has, in a housing, a pair of connection sockets with which a pair of connection terminals of a plug used in a DC electrical equipment is adapted to be detachably electrically connected. The DC receptacle includes a circuit opening/closing unit configured to open or close a power line; and a connection verification unit for verifying the connection of the plug to the receptacle. The circuit opening/closing unit opens or closes the power line depending on the connection state between the plug and the receptacle detected by the connection verification unit.

## Description

### Field of the Invention

The present invention relates to a DC (direct current) receptacle and a plug for DC wiring.

### Background of the Invention

Recently, solar cells and fuel cells have been widely spread. The current generated in the solar cells is DC. The DC is converted into AC, using a converter, to be used at home or provided for sale. Since electric appliances generally operate with DC using an AC-DC converter for converting AC into DC, the generated current is converted from DC to AC using a converter, and the AC is then converted into DC using the AC-DC converter. In this case, almost about 20% of the originally generated power is not used but lost depending on the conversion efficiency.

For this reason, recently, DC power generated by a photovoltaic power generation facility is stored in a storage battery such as a lithium-ion battery, and current is supplied from the storage battery to a DC receptacle installed in a house or the like. In addition, there has been introduced a DC connection device, which is used by connecting a plug of a DC device, such as an illuminator or an electrical appliance that operates by receiving the supplied DC power, to the DC receptacle.

Meanwhile, there has been disclosed a DC connection device in which the timings at which a pair of connection terminals of a plug is disconnected from respective connection sockets of a receptacle are made different from each other, thereby preventing an arc from being generated at the connection terminals of the plug (see, e.g., Japanese Patent Application Publication No. 2009-146777). Also, there has been disclosed a DC receptacle which can supply constant DC voltage to a DC device (see, e.g., Japanese Patent Application Publication No. 2009-146827).

However, if the receptacle and plug in the conventional DC connection device has the same structure as a conventional AC receptacle and AC plug, the plug may be disconnected from the receptacle even while current flows therethrough. In this case, an arc may be generated between the connection terminals of the plug and the connection sockets of the receptacle, which is problematic. Particularly, unlike AC, DC has a constant value with no zero-cross point of current and voltage. Therefore, if an arc is generated, it is difficult for the arc to disappear, and the arc is very dangerous.

### Summary of the Invention

In view of the above, the present invention provides a receptacle and a plug for DC wiring, in which can have further improved safety by surely preventing the generation of an arc when the plug using DC is inserted into or removed from the receptacle.

In accordance with an aspect of the invention, there is provided a DC receptacle having, in a housing, a pair of connection sockets with which a pair of connection terminals of a plug used in a DC electrical equipment is adapted to be detachably electrically connected, the receptacle including: a circuit opening/closing unit configured to open or close a power line electrically connected to the connection sockets; and a connection verification unit configured to verify the connection of the plug to the receptacle, wherein the circuit opening/closing unit opens or closes the power line depending on the connection state between the plug and the receptacle detected by the connection verification unit.

Preferably, the circuit opening/closing unit has a relay, wherein the connection verification unit has a conductive contact adapted to be contacted with a conductive terminal of the plug, and wherein the relay is configured to turn on when the contact and the terminal are in a contact state and turn off when the contact and the terminal are in a non-contact state.

Preferably, the DC receptacle further includes a current measurement unit for measuring a current value of current flowing through the power line; a locking mechanism unit for fixing the plug to the receptacle; and a control unit for controlling the operation of the circuit opening/closing unit depending on the connection state between the contact and the terminal and for controlling the locking mechanism unit so that the plug is not removed from the receptacle when the current value is measured by the current measurement unit.

Preferably, the connection verification unit is a movable piece which moves in a predetermined direction in response to the movement of a locking mechanism unit of the plug for fixing the plug to the receptacle, and wherein the circuit opening/closing unit is configured to close the power line by the movement of the movable piece to a predetermined position when the locking mechanism unit is in a lock state and open the power line by the return of the movable piece from the predetermined position when the locking mechanism unit is in a release state.

Preferably, wherein the circuit opening/closing unit is a breaker connected to the receptacle through a signal line and the power line and provided outside the receptacle, wherein the connection verification unit transmits information on connection between the receptacle and the plug to the breaker through the signal line, and wherein the breaker opens or closes the power line based on the corresponding connection information.

Preferably, the DC receptacle further includes a current measurement unit for measuring a current value of current flowing through the power line; a display unit for displaying a conducting state of the power line; and a control unit for controlling the display unit to display the conducting state when the current value is measured by the current measurement unit.

Preferably, the DC receptacle further includes a display unit for displaying a conducting state of the power line, wherein the control unit controls the display unit to display the conducting state when the current value is measured by the current measurement unit.

Preferably, the display unit is a light emitting diode or a liquid crystal display unit.

In accordance with another aspect of the invention, there is provided A plug which is adapted to be used corresponding to the DC receptacle.

In the receptacle and the plug for DC wiring in accordance with the present invention, the circuit opening/closing unit opens or closes the power line depending on a connection state between the plug and the receptacle, which is detected by the connection verification unit provided in the receptacle. For this reason, it is possible to further improve safety by surely preventing the generation of an arc when the plug using DC is inserted into or removed from the receptacle.

### Brief Description of the Drawings

The objects and features of the present invention will become apparent from the following description of preferred embodiments, given in conjunction with the accompanying drawings, in which:
Figs. 1A and 1B are schematic sectional views of a receptacle and a plug for DC wiring in accordance with a first embodiment of the present invention;
Fig. 2 is a schematic sectional view of a receptacle and a plug for DC wiring in accordance with a second embodiment of the present invention;
Fig. 3A is a schematic perspective view of a receptacle and a plug for DC wiring in accordance with a third embodiment of the present invention, and Fig. 3B is a schematic sectional view of the receptacle and the plug for DC wiring;
Figs. 4A to 4C are schematic sectional views illustrating the operation of a receptacle and a plug for DC wiring in accordance with a fourth embodiment of the present invention; and
Fig. 5A is a schematic sectional view of a receptacle and a plug for DC wiring in accordance with a fifth embodiment of the present invention, Fig. 5B is another schematic sectional view of the receptacle and the plug for

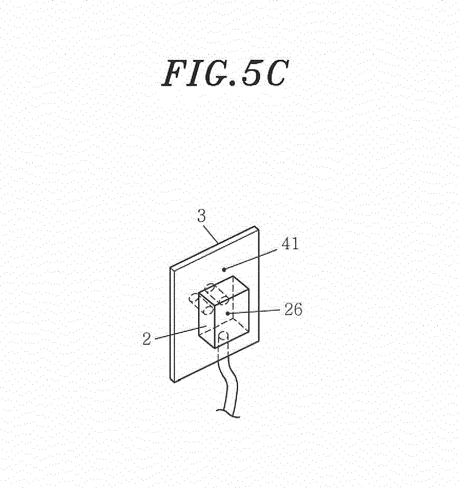

DC wiring, and Fig. 5C is a perspective of the receptacle and the plug for DC wiring.

### Detailed Description of the Preferred Embodiments

Hereinafter, embodiments of the present invention will be described with reference to the accompanying drawings which form a part hereof. In the drawings, the same reference numerals are used for the same or like parts and redundant description thereof will be omitted.

### (First Embodiment)

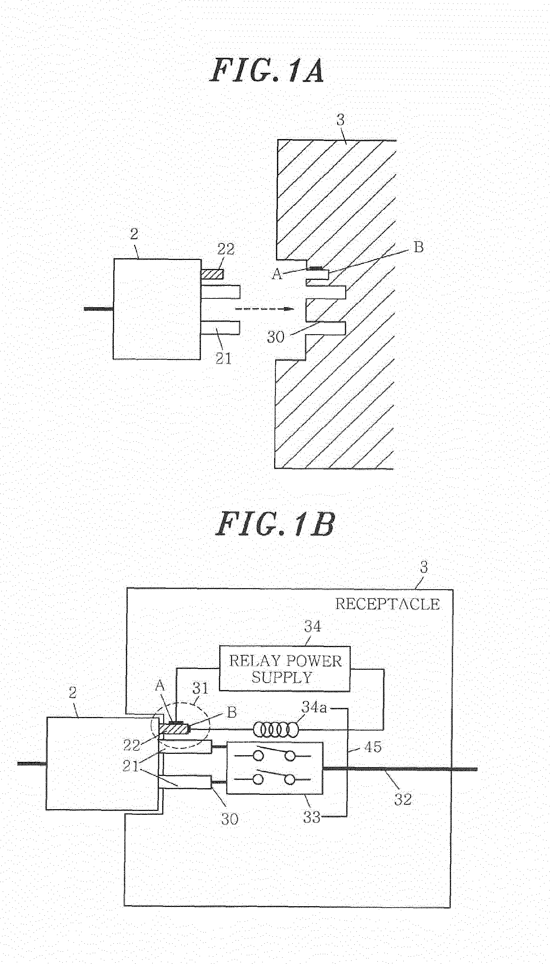

A receptacle 3 and a plug 2 for DC wiring in accordance with a first embodiment are shown in Fig. 1. The plug 2 includes a pair of connection terminals 21 used in electrical equipment which operates with DC, and is used for DC distribution. In addition, the plug 2 further includes a terminal 22 for connection verification, which has conductivity of a metal member or the like and is used to verify the connection between the plug 2 and the receptacle 3. The plug 2 is also used as a plug of an electric appliance such as an illuminator, PC or liquid crystal television, in which DC is used.

The receptacle 3 is installed indoors, for example, on a wall or a floor and allows the plug 2 to be removably inserted into the receptacle 3. The receptacle 3 has, in a housing thereof, a pair of connection sockets 30 for DC feeding, and the connection terminals 21 of the plug 2 are electrically connected to the connection sockets 30. The receptacle 3 is provided with a connection verification unit 31 for verifying the connection of the terminal 22 of the plug 2 to the receptacle 3 using two contacts A and B, a switch 33 connected in series to a power line 32, a coil 34a which allows the switch 33 to be in a closed state (ON) when current flows in the coil 34a and which allows the switch 33 to be in an open state (OFF) when no current flows in the coil 34a, and a relay power supply 34 for supplying power to the coil 34a. Here, the switch 33 and the coil 34a constitute a relay 45 serving as a circuit opening/closing unit.

The connection verification unit 31 has the two contacts A and B for contacting the terminal 22. If the terminal 22 of the plug 2 is inserted into the receptacle 3, current flows through an electric circuit including the connection verification 31, the relay power supply 34 and the coil 34a. While the plug 2 is not inserted into the receptacle 3, the switch 33 is in the open state (OFF). While the plug 2 is inserted into the receptacle 3, the switch 33 is in the closed state (ON) by means of electromagnetic operation of the coil 34a.

Next, the operation of the receptacle 3 and the plug 2 for DC wiring in accordance with the first embodiment will be described. If the plug 2 is inserted into the receptacle 3, the connection terminals 21 are connected to the connection sockets 30, and the terminal 22 of the plug 2 is then connected to the contacts A and B. The power from the relay power supply 34 flows in the coil 34a, so that the switch 33 becomes in the closed state (ON) to start applying current to the plug 2. Meanwhile, when the plug 2 is removed from the receptacle 3, the contact B of the connection verification unit 31 is separated from the terminal 22 and the switch 33 immediately becomes in the open state (OFF) before the connection terminals 21 are separated from the connection sockets 30, and then, the connection terminals 21 are separated from the connection sockets 30.

As described above, in the receptacle 3 and the plug 2 for DC wiring in accordance with the first embodiment, the verification of a connection state in the connection verification unit 31 is interlinked with the on/off operation of the switch 33. Thus, when the plug 2 is not inserted, there is no voltage difference between the connection sockets 30 of the receptacle 3. In addition, even when the plug 2 is unintentionally removed, the switch 33 is turned off simultaneously with the start of the removal of the plug 2 before the connection terminals 21 are separated from the connection sockets 30. Thus, it is possible to surely prevent an arc from being generated between the connection terminals 21 of the plug 2 and the connection sockets 30 of the receptacle 3, which improves safety.

### (Second Embodiment)

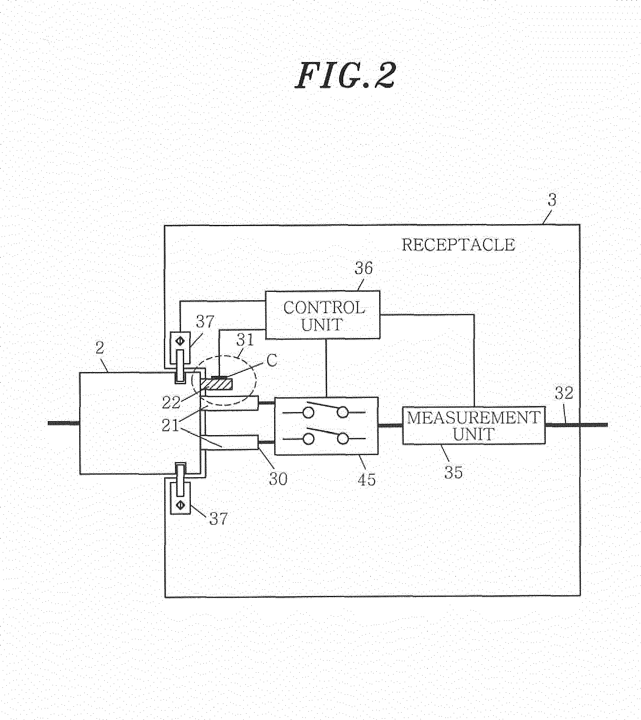

Unlike the configuration of the first embodiment, in a receptacle 3 and a plug 2 for DC wiring in accordance with a second embodiment, the receptacle 3 includes a measurement unit 35, a control unit 36 and a locking mechanism unit 37 as shown in Fig. 2. The measurement unit 35 includes an ammeter or the like, which is connected in series to the power line 32 and transmits a detected current value to the control unit 36. The control unit 36 has a CPU and controls a switch of the relay 45 to be turned on when the connection between the plug 2 and the receptacle 3 is verified by the connection verification unit 31. The control unit 36 operates the locking mechanism unit 37 to make the plug 2 not be removed from the receptacle 3 while the current value is detected by the measurement unit 35. The locking mechanism unit 37 is connected to the control unit 36 and is automatically operated to fix or release the plug 2 based on a predetermined signal from the control unit 36.

Next, the operation of the receptacle 3 and the plug 2 for DC wiring in accordance with the second embodiment will be described. When the plug 2 is inserted, the control unit 36 detects the connection between the plug 2 and the receptacle 3 through the contact between a contact C of the connection verification unit 31 and the terminal 22 of the plug 2, and turns on the switch of the relay 45 that is an opening/closing mechanism unit. Furthermore, if the current value is detected by the measurement unit 35, the control unit 36 operates and controls a removal prevention mechanism of the locking mechanism unit 37 to allow the plug 2 not to be removed from the receptacle 3.

Meanwhile, when the current is not measured by the measurement unit 35, the control unit 36 releases the locking mechanism unit 37 to allow the plug 2 to be removed. In the state in which the plug 2 is removed from the receptacle 3, the contact C of the connection verification unit 31 is separated from the terminal 22. Therefore, the control unit 36 detects the separation between the plug 2 and the receptacle 3 and turns off the switch of the relay 45.

As described above, in the receptacle 3 and the plug 2 for DC wiring in accordance with the second embodiment, the contact C of the connection verification unit 31 contacts the terminal 22 of the plug 2, and a current is then measured by the measurement unit 35. If the current is detected by the measurement unit 35, the control unit 36 operates the locking mechanism unit 37 to allow the plug 2 not to be removed from the receptacle 3. For this reason, it is possible to prevent the plug 2 from being unintentionally removed from the receptacle 3 while current flows through the plug 2, which prevents the generation of an arc and improve safety.

The operation of the second embodiment is similar to that of the first embodiment. When the plug 2 is inserted into the receptacle 3, the terminal 22 of the plug 2 is preferably contacted with the contact C of the connection verification unit 31 after the connection terminals 21 are connected to the connection sockets 30. When the plug 2 is removed from the receptacle 3, the contact C of the connection verification unit 31 is preferably separated from the terminal 22 before the connection terminals 21 are separated from the connection sockets 30.

### (Third Embodiment)

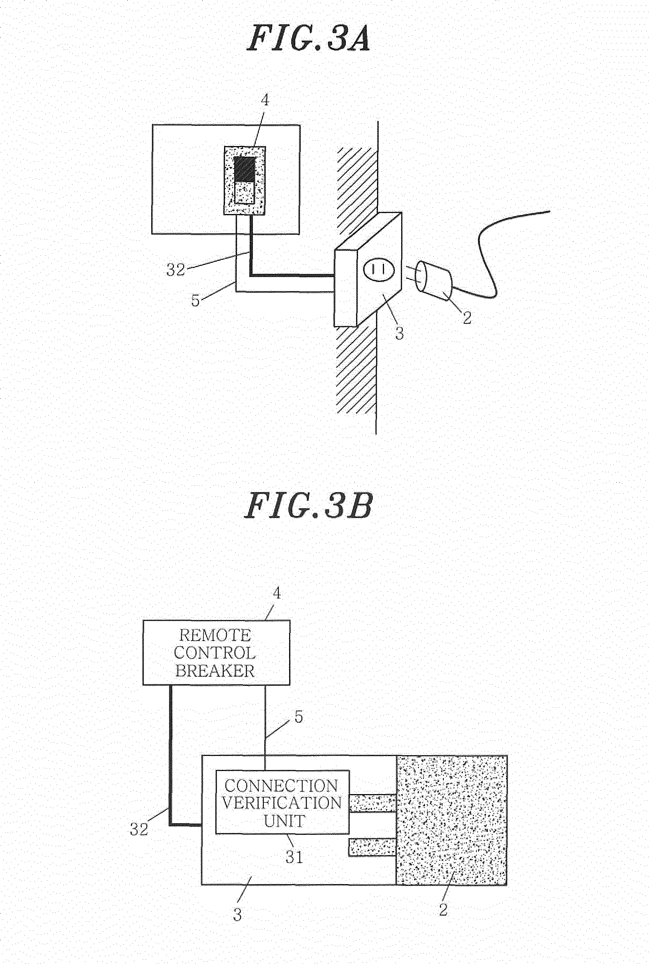

In a receptacle 3 and a plug 2 for DC wiring in accordance with a third embodiment, as shown in Figs. 3A and 3B, the receptacle 3 is connected to a remote control breaker 4 that is a breaker for wiring through the power line 32 and a signal line 5. The connection verification unit 31 has a function of transmitting a bit signal or the like, which represents a connection state between the plug 2 and the receptacle 3, to the remote control breaker 4 through the signal line 5. The connection verification unit 31 is a mechanical button and may verify the connection state between the plug 2 and the receptacle 3 based on the conducting state thereof.

Next; the operation of the receptacle 3 and the plug 2 for DC wiring in accordance with the third embodiment will be described. When the plug 2 is inserted into the receptacle 3, the connection verification unit 31 transmits the information on connection between the plug 2 and the receptacle 3 to the remote control breaker 4 through the signal line 5. Then, if the remote control breaker 4 receives the connection information indicating the connection between the plug 2 and the receptacle 3, the remote control breaker 4 turns on (in the closed state). Meanwhile, when the plug 2 is removed from the receptacle 3, the connection verification unit 31 transmits the connection information corresponding to the disconnection between the plug 2 and the receptacle 3 to the remote control breaker 4, and the remote control breaker 4 receiving the corresponding information turns off (in the open state). That is, the remote control breaker 4 provided in the third embodiment serves as a circuit opening/closing unit.

As described above, in the receptacle 3 and the plug 2 for DC wiring in accordance with the third embodiment, the remote control breaker 4 is in the disconnection between the plug 2 and the receptacle 3 when the connection of the plug 2 to the receptacle 3 is not verified by the connection verification unit 31. For this reason, no voltage is generated between the connection sockets 30 of the receptacle 3 to improve safety, and it is possible to prevent the generation of an arc.

Further, the remote control breaker 4 that is a circuit opening/closing mechanism is provided outside the receptacle 3, and thus the configuration of the receptacle 3 can be simplified.

The operation of the third embodiment is similar to that of the first embodiment. When the plug 2 is inserted into the receptacle 3, the connection verification unit 31 is preferably configured to verify that the plug 2 is inserted into the receptacle 3 after the connection terminals 21 have been connected to the connection sockets 30. Then, the connection verification unit 31 transmits the connection information to the remote control breaker 4. When the plug 2 is removed from the receptacle 3, the connection verification unit 31 is preferably configured to verify that the plug 2 has been removed from the receptacle 3 before the connection terminals 21 are separated from the connection sockets 30. Then, the connection verification unit 31 transmits the connection information to the remote control breaker 4.

### (Fourth Embodiment)

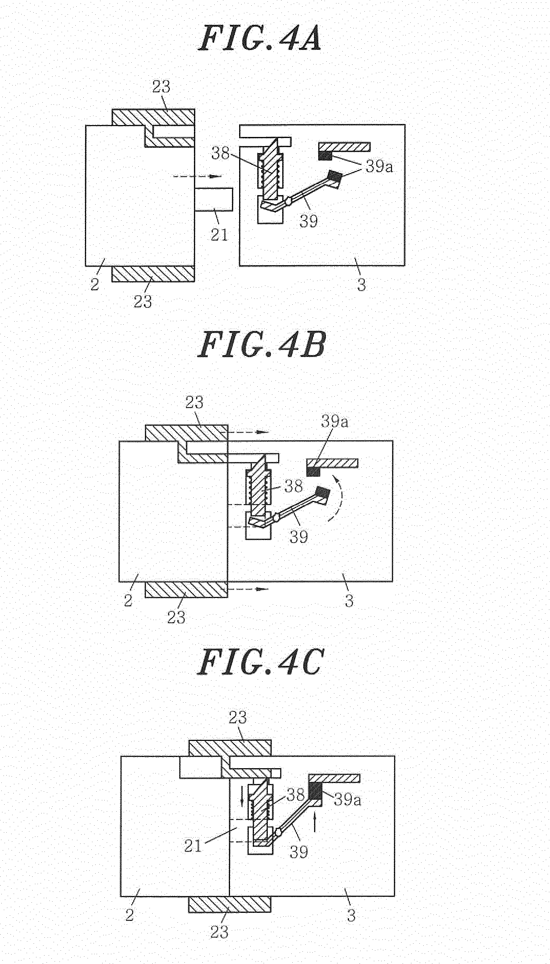

In a receptacle 3 and a plug 2 for DC wiring in accordance with a fourth embodiment, as shown in Figs. 4A to 4C, the plug 2 is provided with a locking mechanism unit 23 that is a removal prevention mechanism. The receptacle 3 is provided with a movable piece 38 serving as a connection verification unit, and a pair of opening/closing members 39 for mechanically opening or closing the power line 32 in response to the movement of the movable piece 38 depending on the lock operation of the locking mechanism unit 23. That is, the opening/closing members 39 provided in the fourth embodiment serve as a circuit opening/closing unit.

The operation of the receptacle 3 and the plug 2 for DC wiring in accordance with the fourth embodiment will be described. The movable piece 38 does not operate in the state before the plug 2 is inserted into the receptacle 3 as shown in Fig. 4A and in the state in which the plug 2 is just inserted into the receptacle 3 as shown in Fig. 4B. Thus, since contacts 39a of the pair of opening/closing members 39 are separated from each other, no current flows through the power line 32. In addition, if the locking mechanism unit 23 of the plug 2 performs locking operation as shown in Fig. 4C, i.e., if the locking mechanism unit 23 is moved in the direction from the plug 2 to the receptacle 3 in the state where the plug 2 is inserted in the receptacle 3, the movable piece 38 moves downward in Figs. 4A to 4C. Accordingly, the movable piece 38 pushes one end portions of the opening/closing members 39, so that the contacts 39a contact each other and the power line 23 is in a conducting state. In the conducting state, the plug 2 is fixed by the locking mechanism unit 23 so as not to be removed from the receptacle 3.

Meanwhile, in a case when the plug 2 is removed from the receptacle 3, the locking mechanism unit 23 is released. That is, if the locking mechanism unit 23 is moved in the direction from the receptacle 3 to the plug 2 in the state in which the plug 2 is inserted in the receptacle 3, the movable piece 38 moves upward in Figs. 4A to 4C. Accordingly, the state in which the movable piece 38 pushes the one end portions of the opening/closing members 39 is released, and the contacts 39a of the opening/closing members 39 are separated from each other, so that no current flows through the power line 32.

In accordance with the configuration described above, in the receptacle 3 and the plug 2 for DC wiring in accordance with the fourth embodiment, the contacts 39a of the opening/closing members 39 are always in the contact state, in the lock state of the locking mechanism unit 23, in which the plug 2 cannot be freely removed from the receptacle 3. Furthermore, in the release state of the locking mechanism unit 23, the contacts 39a of the opening/closing members 39 are always in the separation state, in which the plug 2 can be freely removed from the receptacle 3. For this reason, it is possible to prevent the plug 2 from being unintentionally removed from the receptacle 3 in the conducting state and to prevent an arc from being generated even when the plug 2 is removed from the receptacle 3, thereby improving safety.

### (Fifth Embodiment)

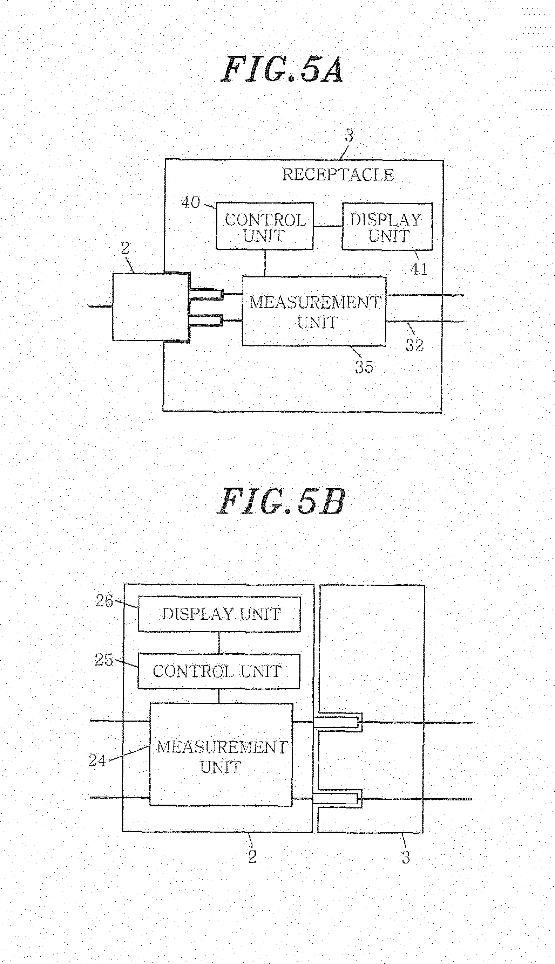

In a receptacle 3 and a plug 2 for DC wiring in accordance with a fifth embodiment, as shown in Fig. 5A, the receptacle 3 is provided with a measurement unit 35 for measuring a current value of current flowing therethrough, and a control unit 40 for displaying the conducting state of the receptacle 3 on an display unit 41 when the current value is detected from the measurement unit 35. As shown in Fig. 5B, the plug 2 is provided with a measurement unit 24 for measuring a current value of current flowing therethrough, and a control unit 25 for displaying the conducting state of the plug 2 on a display unit 26 when the current value is detected from the measurement unit 22. As shown in Fig. 5C, the display unit 26 or 41 may be, for example, a light emitting diode (LED) or a liquid crystal display unit. The LED may emits red light in the conducting state and emits green light or turns off the light in the non-conducting state. The liquid crystal display unit may display a current value.

The control unit 40 or 25 and the display unit 41 or 26 may be provided in either one of the receptacle 3 or the plug 2.

In accordance with the configuration described above, in the receptacle 3 and the plug 2 for DC wiring in accordance with the fifth embodiment, the conducting state may be displayed on at least one of the display unit 26 of the plug 2 and the display unit 41 of the receptacle 3. This makes users pay attention not to remove the plug 2 in the conducting state, thereby improving safety.

The fifth embodiment may be used in combination with the first to fourth embodiments. Furthermore, in a case where the embodiment shown in Fig. 5A is combined with the second embodiment, the function of the control unit 40 shown in Fig. 5A may be added to the control unit 36 provided in the second embodiment.

While the invention has been shown and described with respect to the embodiments, the present invention is not limited thereto. It will be understood by those skilled in the art that various changes and modifications may be made without departing from the scope of the invention as defined in the following claims.

## Claims

1. A DC receptacle having, in a housing, a pair of connection sockets with which a pair of connection terminals of a plug used in a DC electrical equipment is adapted to be detachably electrically connected, the receptacle comprising:
a circuit opening/closing unit configured to open or close a power line electrically connected to the connection sockets; and
a connection verification unit configured to verify the connection of the plug to the receptacle,
wherein the circuit opening/closing unit opens or closes the power line depending on the connection state between the plug and the receptacle detected by the connection verification unit.

2. The DC receptacle of claim 1, wherein the circuit opening/closing unit has a relay,
wherein the connection verification unit has a conductive contact adapted to be contacted with a conductive terminal of the plug, and
wherein the relay is configured to turn on when the contact and the terminal are in a contact state and turn off when the contact and the terminal are in a non-contact state.

3. The DC receptacle of claim 2, further comprising:
a current measurement unit for measuring a current value of current flowing through the power line;
a locking mechanism unit for fixing the plug to the receptacle; and
a control unit for controlling the operation of the circuit opening/closing unit depending on the connection state between the contact and the terminal and for controlling the locking mechanism unit so that the plug is not removed from the receptacle when the current value is measured by the current measurement unit.

4. The DC receptacle of claim 1, wherein the connection verification unit is a movable piece which moves in a predetermined direction in response to the movement of a locking mechanism unit of the plug for fixing the plug to the receptacle, and
wherein the circuit opening/closing unit is configured to close the power line by the movement of the movable piece to a predetermined position when the locking mechanism unit is in a lock state and open the power line by the return of the movable piece from the predetermined position when the locking mechanism unit is in a release state.

5. The DC receptacle of claim 1, wherein the circuit opening/closing unit is a breaker connected to the receptacle through a signal line and the power line and provided outside the receptacle,
wherein the connection verification unit transmits information on connection between the receptacle and the plug to the breaker through the signal line, and
wherein the breaker opens or closes the power line based on the corresponding connection information.

6. The DC receptacle of any one of claims 1, 2, 4 and 5, further comprising:
a current measurement unit for measuring a current value of current flowing through the power line;
a display unit for displaying a conducting state of the power line; and
a control unit for controlling the display unit to display the conducting state when the current value is measured by the current measurement unit.

7. The DC receptacle of claim 3, further comprising:
a display unit for displaying a conducting state of the power line,
wherein the control unit controls the display unit to display the conducting state when the current value is measured by the current measurement unit.

8. The DC receptacle of claim 6 or 7, wherein the display unit is a light emitting diode or a liquid crystal display unit.

9. A plug which is adapted to be used corresponding to the DC receptacle of any one of claims 1 to 5.
